# EUROPÄISCHE PATENTSCHRIFT

(11) **EP 2 797 396 B1**
(45) Veröffentlichungstag und Bekanntmachung des Hinweises auf die Patenterteilung: **22.05.2019**
(21) Anmeldenummer: 14164748.7
(22) Anmeldetag: 15.04.2014
(51) Int. Cl.: H05K 7/20, H02J 9/06

(54) **Steuerschrank und Industrieroboter mit einem Steuerschrank**
Control cabinet and industrial robot with a control cabinet
Armoire de commande et robot industriel doté d'une armoire de commande

(30) Priorität: 25.04.2013 DE 102013207520
(43) Veröffentlichungstag der Anmeldung: 29.10.2014
(73) Patentinhaber: KUKA Deutschland GmbH, 86165 Augsburg (DE)
(72) Erfinder: Roth, Stefan, 86485 Eisenbrechtshofen (DE)
(74) Vertreter: Ege Lee & Partner Patentanwälte PartGmbB

(56) Entgegenhaltungen:
- EP-A2- 0 124 738
- DE-A1-102008 062 430
- US-A- 4 339 779
- US-A- 5 927 094

## Beschreibung

Die Erfindung betrifft einen Industrieroboter mit einem Steuerschrank.

Industrieroboter umfassen in der Regel einen Roboterarm und eine Steuervorrichtung. Die Steuervorrichtung und gegebenenfalls weitere elektrische und/oder elektronische Komponenten, wie z.B. Leistungselektroniken des Industrieroboters, können in einem Steuerschrank angeordnet sein. Diese Komponenten erzeugen Im Betrieb des Industrieroboters Wärme, welche in die Umgebung des Steuerschranks abgegeben werden muss. Für eine verbesserte Kühlung dieser Komponenten kann der Steuerschrank z.B. einen Lüfter für eine Zwangskonvektion aufweisen. Dieser verbraucht jedoch elektrische Energie.

Die DE 10 2008 062 430 A1 beschreibt einen Steuerschrank, insbesondere für Industrieroboter aufweisend einen Aufnahmeraum für ein Baugruppen-Gehäuse, sowie weitere Steuerbauelemente und/oder Steuerbaugruppen, einen Lüftungsraum, eine den Aufnahmeraum vom Lüftungsraum trennende Zwischenwand, einen im Lüftungsraum angeordneten Wärmetauscher, dessen erste Kühlstrukturen dem Innenkreislauf des Aufnahmeraums zugeordnet und dessen zweite Kühlstrukturen dem Außenkreislauf des Lüftungsraums zugeordnet sind, wobei eine Innenkreislauf-Luftströmung von einem in einem Baugruppen-Gehäuse integrierten Lüfter erzeugt wird.

Die EP 0 124 738 A2 beschreibt einen Industrieroboter mit elektrischem Drehstrom-Einzelantrieb für die Bewegungen in den einzelnen Achsen, bei dem die permanenterregten Drehstrommotoren jeweils für sich über regelbare Stromrichter an einen gemeinsamen Gleichspannungszwischenkreis angeschlossen sind, der über einen Stromrichter aus einem Drehstromnetz gespeist ist, wobei die im Gleichspannungszwischenkreis vorgesehene Kondensatorbatterie für die Aufnahme der bei der dynamischen Abbremsung der Drehstrommotoren über die Stromrichter anfallenden elektrischen Energie ausgelegt ist.

Die US 4,339,779 beschreibt eine elektronische Steuervorrichtung mit einem Lüftermotor, der an eine Versorgungsleitung der elektronischen Steuervorrichtung angeschlossen ist. Der Lüftermotor arbeitet im Falle eines Spannungsabfalls an einer Spannungsversorgung als ein Generator, wobei ein Schalter vorgesehen ist, der die im Generatorbetrieb des Lüftermotors erzeugte Energie an die elektronische Steuervorrichtung leitet, wenn der Schalter den Lüftermotor von der Spannungsversorgung getrennt hat.

Aufgabe der Erfindung ist es, einen energieeffizienteren Steuerschrank eines Industrieroboters anzugeben.

Die Aufgabe der Erfindung wird gelöst durch einen Industrieroboter, aufweisend einen Roboterarm mit mehreren, hintereinander angeordneten und über Gelenke verbundenen Gliedern und mit elektrischen Motoren zum Bewegen der Glieder relativ zueinander, und eine Steuervorrichtung zum Bewegen des Roboterarms, und einen Steuerschrank, aufweisend ein Gehäuse, wenigstens eine innerhalb des Gehäuses angeordnete elektrische und/oder elektronische Komponente, und einen elektromechanischen Energiespeicher, der einen elektrischen Motor und ein drehbar gelagertes Schwungrad aufweist, das mittels des elektrischen Motors in Drehung vesetzbar und eingerichtet ist, einen Luftstrom zum Kühlen der wenigstens einen elektrischen und/oder elektronischen Komponente zu erzeugen, wobei der Industrieroboter eingerichtet ist, in einem ersten Betriebsmodus wenigstens eines der Glieder mittels seines Motors zu bremsen und mittels der dadurch erzeugten elektrischen Energie den
elektrischen Motor anzutreiben, damit dieser das Schwungrad dreht, und in einem zweiten Betriebsmodus den elektrischen Motor des Energiespeichers in einem generatorischen Betrieb zu betreiben, um in dem sich drehenden Schwungrad gespeicherte Energie in elektrische Energie umzuwandeln, welche vorgesehen ist, die elektrischen Motoren des Roboterarms anzutreiben.

Die Erfindung betrifft somit einen Industrieroboter, aufweisend einen Roboterarm mit mehreren, hintereinander angeordneten und über Gelenke verbundenen Gliedern und mit elektrischen Motoren zum Bewegen der Glieder relativ
zueinander, eine Steuervorrichtung zum Bewegen des Roboterarms, und einen Steuerschrank.

Der Steuerschrank umfasst demnach den elektromechanischen Energiespeicher, der das Schwungrad aufweist. Elektromechanische Energiespeicher mit einem Schwungrad sind dem Fachmann im Prinzip beispielsweise aus der WO 2005/110711 A1 bekannt. Diese umfassen einen elektrischen Motor, der das drehbar gelagerte Schwungrad in Drehung versetzt, um insbesondere überschüssige elektrische Energie in Rotationsenergie umzuwandeln. Zu gegebener Zeit kann dann der elektrische Motor in einem Generatorbetrieb betrieben werden, um die in dem sich drehenden Schwungrad gespeicherte Energie wieder in elektrische Energie umzuwandeln. Erfindungsgemäß wird das sich drehende Schwungrad jedoch nicht nur zum Speichern von Energie verwendet, sondern auch zum Kühlen der wenigstens einen Komponente des Steuerschranks. Dadurch kann gegebenenfalls auf einen Lüfter verzichtet werden, wodurch der elektrische Energieverbrauch des Steuerschranks bzw. des erfindungsgemäßen Industrieroboters weiter verringert werden kann.

Der Steuerschrank kann vorzugsweise einen innerhalb des Gehäuses angeordneten, entwärmenden Innenraum, innerhalb dem die wenigstens eine Komponente angeordnet ist, aufweisen. Zusätzlich oder alternativ kann der erfindungsgemäße Steuerschrank vorzugsweise einen Luftkanal aufweisen, in dem zumindest das Schwungrad angeordnet ist, um den Luftstrom durch den Luftkanal zu leiten.

Durch diese Kombination ergibt sich zudem einen Schutz der Trägheit (Schwungrad) als relativ schnell drehende Masse durch den Lüftungskanal bzw. Luftkanal. Es ist auch möglich, den Einbauraum für den Energiespeicher nur unwesentlich größer auszuführen als wenn ein konventioneller Lüfter verwendet werden würde.

Eine Kühlung des Energiespeichers kann somit auch entsprechend der Kühlung eines Lüftermotors ausgeführt sein.

Für eine verbesserte Kühlung kann nach einer Ausführungsform des Steuerschranks dieser einen zwischen dem Luftkanal und dem entwärmenden Innenraum angeordneten Wärmetauscher aufweisen. Dann ist das Schwungrad vorzugsweise eingerichtet bzw. derart im Luftkanal angeordnet, dass es den Luftstrom am Wärmetauscher vorbei und/oder über den Wärmetauscher zu leiten vermag.

Für einen verbesserten Luftstrom und damit für eine verbesserte Kühlung der wenigstens einen Komponente kann das Schwungrad derart strukturiert sein, dass es den Luftstrom definiert leitet. So kann beispielsweise das Schwungrad die Form eines Lüfterrades aufweisen.

Eine elektronische bzw. elektrische Komponente des Steuerschranks ist beispielsweise eine Steuervorrichtung des erfindungsgemäßen Industrieroboters. Eine elektronische bzw. elektrische Komponente des Steuerschranks kann aber auch eine Leistungselektronik bzw. Leistungselektroniken sein, die vorgesehen ist bzw. sind, elektrische Motoren des Roboterarms anzusteuern. Hierbei können vorteilhafterweise auch andere alternierend arbeitende Maschinen, insbesondere Pressen, Drehtische oder Kalander, mit dem erfindungsgemäßen Steuerschrank gesteuert werden.

Nach einer Ausführungsform des erfindungsgemäßen Industrieroboters umfassen die Leistungselektroniken für die Motoren des Roboterarms einen gemeinsamen Gleichrichter zum Erzeugen einer Gleichspannung aus einer elektrischen Netzwechselspannung oder einer dreiphasigen elektrischen Netzspannung, einen, dem Gleichrichter nachgeschalteten gemeinsamen Zwischenkreis und dem Zwischenkreis nachgeschaltete Wechselrichter, von denen jeweils einer einen der elektrischen Motoren des Roboterarms mit einer elektrischen Spannung versorgt. Die Wechselrichter werden beispielsweise mittels der Steuervorrichtung angesteuert. Der erfindungsgemäße Industrieroboter umfasst demnach vorzugsweise elektrische Antriebe, insbesondere geregelte elektrische Antriebe, deren Leistungselektroniken vorzugsweise im Steuerschrank, gegebenenfalls innerhalb dessen entwärmenden Innenraum angeordnet sind und vorzugsweise mittels des Schwungrades gekühlt werden. Zumindest einige, wenn nicht gar alle elektrischen Antriebe des Industrieroboters teilen sich einen gemeinsamen Zwischenkreis, welcher insbesondere einen Zwischenkreiskondensator aufweist.

Gegebenfalls kann auch dem elektrischen Motor des Energiespeichers ein Wechselrichter vorgeschaltet sein, welcher dem gemeinsamen Zwischenkreis der Leistungselektroniken des Industrieroboters nachgeschaltet ist und insbesondere mittels der Steuervorrichtung ansteuerbar ist. Somit kann in relativ einfacher Weise z.B. während eines elektrischen Bremsens eines der Glieder des Roboterarms die von dem entsprechenden elektrischen Motor erzeugte elektrische Energie über den Zwischenkreis an den Wechselrichter des Energiespeichers geleitet werden, damit dessen elektrischer Motor das Schwungrad antreibt. Die Wechselrichter, also die Wechselrichter für die Motoren des Roboterarms und des Wechselrichters des Energiespeichers können mittels der Steuervorrichtung des Industrieroboters angesteuert werden. Der elektromechanische Energiespeicher stellt somit eine zusätzliche Roboterachse dar.

Erfindungsgemäß ist der Industrieroboter eingerichtet, in einem ersten Betriebsmodus wenigstens eines der Glieder mittels seines Motors zu bremsen und mittels der dadurch erzeugten elektrischen Energie den elektrischen Motor des elektromechanischen Energiespeichers anzutreiben, damit dieser das Schwungrad dreht. Im ersten Betriebsmodus wird demnach überschüssige, beim Bremsen entstehende elektrische Energie in Rotationsenergie umgewandelt.

Erfindungsgemäß ist der Industrieroboter außerdem eingerichtet, in einem zweiten Betriebsmodus den elektrischen Motor des Energiespeichers in einem generatorischen Betrieb zu betreiben, um in dem sich drehenden Schwungrad gespeicherte Energie in elektrische Energie umzuwandeln. Diese elektrische Energie ist vorgesehen, die elektrischen Motoren des Roboterarms anzutreiben.

Es kann auch vorgesehen sein, in einem dritten Betriebsmodus den elektrischen Motor des Energiespeichers im Leerlauf zu betreiben. Dieser Betriebsmodus ist dann vorteilhaft, wenn aktuell weder ein Glied des Roboterarms gebremst oder beschleunigt wird. Auch kann der erfindungsgemäße Industrieroboter im dritten Betriebsmodus betrieben werden, wenn zwar der Industrieroboter aktuell elektrische Energie benötigt, ein Abbremsen des Schwungrades aufgrund der aktuell benötigten Kühlung ungünstig ist.

Sollte eine verstärkte Kühlung der wenigstens einen Komponente aktuell nötig sein, dann kann es gemäß einer Variante des erfindungsgemäßen Industrieroboters vorgesehen sein, diesen in einem vierten Betriebsmodus zu betreiben, in dem der elektrischen Motor des Energiespeichers mittels elektrischer Energie aus einem elektrischen Versorgungsnetz angetrieben wird, also über den Zwischenkreis mit elektrischer Energie versorgt wird, obwohl aktuell keines der Glieder des Roboterarms elektromotorisch gebremst wird.

Vorteilhaft beim erfindungsgemäßen Industrieroboter kann der Umstand sein, dass dieser unter Umständen relativ intensiv arbeitet, deshalb einen relativ hohen Energiespeicherbedarf aufweist und damit auch relativ viel Lüftung verursacht. Eine Regelung des Schwungrades kann gegebenenfalls darüber hinaus mit einer frei wählbaren Minimal-Drehzahl des Schwungrades erfolgen.

Ein Ausführungsbeispiel der Erfindung ist exemplarisch in den beigefügten schematischen Zeichnungen dargestellt. Es zeigen:
- Fig. 1: einen Industrieroboter mit einem Roboterarm und einem Steuerschrank und
- Fig. 2: den Steuerschrank.

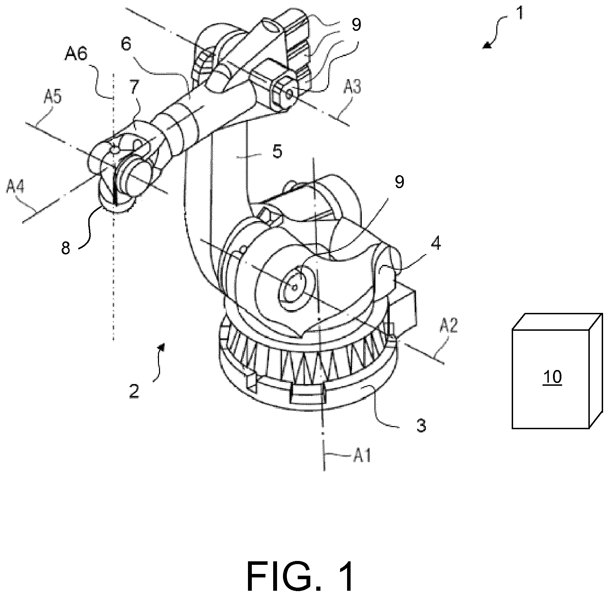

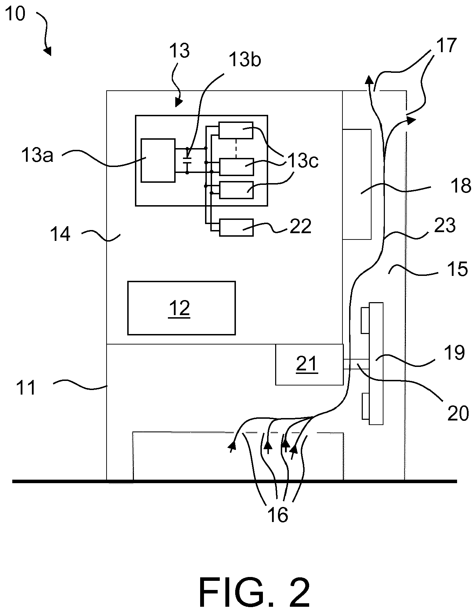

Die Fig. 1 zeigt einen Industrieroboter 1 mit einem Roboterarm 2 und einem Steuerschrank 10 in einer perspektivischen Darstellung zeigt. Die Fig. 2 zeigt eine Seitenansicht des Steuerschranks 10 in einer geschnittenen Darstellung.

Der Roboterarm 2 umfasst im Falle des vorliegenden Ausführungsbeispiels mehrere, nacheinander angeordnete und mittels Gelenke verbundene Glieder. Bei den Gliedern handelt es sich insbesondere um ein ortsfestes oder bewegliches Gestell 3 und ein relativ zum Gestell 3 um eine vertikal verlaufende Achse A1 drehbar gelagertes Karussell 4. Weitere Glieder des Roboterarms 2 sind im Falle des vorliegenden Ausführungsbeispiels eine Schwinge 5, ein Ausleger 6 und eine vorzugsweise mehrachsige Roboterhand 7 mit einer z.B. als Flansch 8 ausgeführten Befestigungsvorrichtung zum Befestigen eines nicht näher dargestellten Endeffektors. Die Schwinge 5 ist am unteren Ende z.B. an einem nicht näher dargestellten Schwingenlagerkopf auf dem Karussell 4 um eine vorzugsweise horizontale Achse A2 schwenkbar gelagert. Am oberen Ende der Schwinge 5 ist wiederum um eine ebenfalls vorzugsweise horizontale Achse A3 der Ausleger 6 schwenkbar gelagert. Dieser trägt endseitig die Roboterhand 7 mit ihren vorzugsweise drei Achsen A4, A5, A6.

Um den Industrieroboter 1 bzw. dessen Roboterarm 2 zu bewegen, umfasst dieser in allgemein bekannter Weise mit einer innerhalb eines Gehäuses 11 des Steuerschranks 10 angeordneten Steuervorrichtung 12 verbundene elektrische Antriebe. In der Figur 1 sind nur einige der elektrischen Motoren 9 dieser Antriebe gezeigt, welche im oder am Roboterarm 2 befestigt sind. Leistungselektroniken 13 der Antriebe sind im Falle des vorliegenden Ausführungsbeispiels ebenfalls innerhalb des Gehäuses 11 des Steuerschranks 10 angeordnet.

Die Leistungselektroniken 13 umfassen im Falle des vorliegenden Ausführungsbeispiels einen Gleichrichter 13a, welcher aus der Netzspannung eine Gleichspannung erzeugt, einen dem Gleichrichter 13a nachgeschalteten Zwischenkreis mit einem Zwischenkreiskondensator 13b und mehrere, dem Zwischenkreiskondensator 13b nachgeschaltete Umrichter bzw. Wechselrichter 13c. Von den Wechselrichtern 13c ist jeweils einer einem der elektrischen Motoren 9 vorgeschaltet, sodass die Wechselrichter 13c ihre Motoren 9 mit geeigneten elektrischen dreiphasigen Spannungen versorgen, wie dies dem Fachmann im Prinzip bekannt ist.

Auf der Steuervorrichtung 12, welche z.B. als ein Computer ausgeführt ist, läuft ein Rechenprogramm, mittels dem die Steuervorrichtung 12 im Betrieb des Industrieroboters 1 diesen beispielsweise derart ansteuert, dass der Flansch 8 oder ein sogenannter Tool Center Point eine vorbestimmte Bewegung ausführt. Gegebenenfalls regelt die Steuervorrichtung 12 die Antriebe, wie dies im Prinzip dem Fachmann bekannt ist. Gegebenenfalls sind die elektrischen Antriebe geregelte Antriebe und die Steuervorrichtung 12 erzeugt Soll-Signale für die geregelten Antriebe bzw. deren Wechselrichter 13c. Die Steuervorrichtung 10 steuert z.B. in geeigneter und dem Fachmann im Prinzip bekannter Weise die Wechselrichter 13c an.

Im Falle des vorliegenden Ausführungsbeispiels umfasst der Steuerschrank 10 einen innerhalb des Gehäuses 11 angeordneten entwärmenden Innenraum 14, in dem insbesondere die Steuervorrichtung 12 und die Leistungselektroniken 13 angeordnet sind.

Im Falle des vorliegenden Ausführungsbeispiels weist der Steuerschrank 10 einen Luftkanal 15 auf, welcher innerhalb des Gehäuses 11 und außerhalb des entwärmenden Innenraums 14 angeordnet ist. Der Luftkanal 15 weist erste Öffnungen 16 und zweite Öffnungen 17 auf. Die ersten Öffnungen 16 sind z.B. in einem unteren Bereich des Steuerschranks 10 bzw. dessen Gehäuse 11 und die zweiten Öffnungen 17 sind z.B. in einem oberen Bereich des Steuerschranks 10 bzw. dessen Gehäuse 11, insbesondere in der Decke des Gehäuses 11 des Steuerschrank 10 angeordnet.

Des Weiteren kann der Steuerschrank 10 einen Wärmetauscher 18 aufweisen, der außerhalb des entwärmenden Innenraums 14 mit diesem wärmeleitend verbunden ist. Der Wärmetauscher 18 ist insbesondere innerhalb des Luftkanals 15 angeordnet, sodass über den Wärmetauscher 18 Wärme des entwärmenden Innenraums 14 durch den Luftkanal 15 in die Umgebung des Steuerschranks 10 gelangen kann.

Im Falle des vorliegenden Ausführungsbeispiels weist der Industrieroboter 1 ein Schwungrad 19 auf, welches mittels einer Welle 20 drehbar gelagert ist. Das Schwungrad 19 bzw. die Welle 20 sind mit einem elektrischen Motor 21 gekoppelt, indem z.B. die Welle 20 auch den Rotor des elektrischen Motors 21 darstellt.

Im Falle des vorliegenden Ausführungsbeispiels ist dem Motor 21 des Schwungrads 19 ein Umrichter bzw. Wechselrichter 22 vorgelagert, welcher ebenfalls mit dem Zwischenkreiskondensator 13b verbunden ist. Dieser Wechselrichter 22 ist ebenfalls mit der Steuervorrichtung 10 verbunden, damit diese den Wechselrichter 22 derart anzusteuern vermag, dass wenn einer der Glieder des Roboterarms 2 motorisch gebremst wird, die aufgrund dieses Bremsens erzeugte elektrische Energie zum Antreiben des elektrischen Motors 21 des Schwungrads 19 verwendet wird. In diesem Fall, der einem ersten Betriebsmodus entspricht, wird der elektrische Motor 21 des Schwungrads 19 motorisch betrieben und beschleunigt somit das Schwungrad 19, sodass dieses sich dreht.

Bremst dagegen keines der Glieder des Roboterarms 2 elektrisch, dann wird in einem zweiten Betriebsmodus der elektrische Motor 21 in einem generatorischen Betrieb betrieben und speist somit elektrische Energie in den Zwischenkreiskondensator 13b ein. Alternativ oder zusätzlich kann der elektrische Motor 21 des Schwungrads 21 auch in einem dritten Betriebsmodus betrieben werden, in dem er im Leerlauf betrieben wird und somit weder elektrische Energie aufnimmt noch abgibt. Vorzugsweise wird der elektrische Motor 21 des Schwungrads 19 im dritten Betriebsmodus betrieben, wenn keines der Glieder des Roboterarms 2 motorisch gebremst wird.

Im Falle des vorliegenden Ausführungsbeispiels ist das Schwungrad 19 innerhalb des Luftkanals 15 angeordnet und erzeugt während es sich dreht einen Luftstrom 23. Das Schwungrad 19 ist insbesondere derart ausgeführt, dass der Luftstrom 23 Luft durch die ersten Öffnungen 16 ansaugt und über den Wärmetauscher 18 durch die zweiten Öffnungen 17 aus dem Luftkanal 15 fördert. In diesem Fall stellen die ersten Öffnungen 16 Ansaugöffnungen und die zweiten Öffnungen 17 Austrittsöffnungen des Luftkanals 15 dar. Somit entsteht insbesondere bei sich drehendem Schwungrad 19 der Luftstrom 23, welcher den Luftkanal 15 durch die ersten Öffnungen 16 betritt, am Wärmetauscher 18 vorbei strömt und sich erwärmt und den Luftkanal 15 durch die zweiten Öffnungen 17 wieder verlässt.

Damit das Schwungrad 19 einen ausreichend starken Luftstrom 23 erzeugen kann, ist die Schwungrad 19 vorzugsweise mit einer entsprechenden Struktur versehen. So kann z.B. die Schwungrad 19 die Form eines Schaufelrades aufweisen. Der elektrische Motor 21 bzw. das Schwungrad 19 wird somit nicht nur als Energiespeicher verwendet, sondern auch als Lüfter zum Kühlen.

Sollte es nötig sein, das Schwungrad 19 auch ohne elektrischen Bremsens der Glieder des Roboterarms 2 in Drehung zu versetzten und/oder verstärkt zu drehen, dann kann die Steuervorrichtung 10 auch derart eingerichtet sein, den elektrischen Motor 21 des Schwungrades 19 in einem vierten Betriebsmodus motorisch zu betreiben, auch wenn keines der Glieder des Roboterarms 2 aktuell elektrisch gebremst wird.

## Patentansprüche

1. Industrieroboter, aufweisend
- einen Roboterarm (2) mit mehreren, hintereinander angeordneten und über Gelenke verbundenen Gliedern (3-7) und mit elektrischen Motoren (9) zum Bewegen der Glieder (3-7) relativ zueinander,
- eine Steuervorrichtung (10) zum Bewegen des Roboterarms (2), und
- einen Steuerschrank (10), aufweisend
- ein Gehäuse (11),
- wenigstens eine innerhalb des Gehäuses (11) angeordnete elektrische und/oder elektronische Komponente (12, 13, 23), und
- einen elektromechanischen Energiespeicher, der einen elektrischen Motor (21) und ein drehbar gelagertes Schwungrad (19) aufweist, das mittels des elektrischen Motors (21) in Drehung versetzbar und eingerichtet ist, einen Luftstrom (23) zum Kühlen der wenigstens einen elektrischen und/oder elektronischen Komponente (12, 13, 23) zu erzeugen, wobei der Industrieroboter (1) eingerichtet ist, in einem ersten Betriebsmodus wenigstens eines der Glieder (3-7) mittels seines Motors (9) zu bremsen und mittels der dadurch erzeugten elektrischen Energie den elektrischen Motor (21) anzutreiben, damit dieser das Schwungrad (19) dreht, und in einem zweiten Betriebsmodus den elektrischen Motor (21) des Energiespeichers in einem generatorischen Betrieb zu betreiben, um in dem sich drehenden Schwungrad (21) gespeicherte Energie in elektrische Energie umzuwandeln, welche vorgesehen ist, die elektrischen Motoren (9) des Roboterarms (2) anzutreiben.

2. Industrieroboter nach Anspruch 1, bei dem der Steuerschrank (10) einen innerhalb des Gehäuses (11) angeordneten, entwärmenden Innenraum (15) aufweist, innerhalb dem die wenigstens eine Komponente (12, 13, 23) angeordnet ist, und/oder einen Luftkanal (15), in dem zumindest das Schwungrad (19) angeordnet ist, um den Luftstrom (23) durch den Luftkanal (15) zu leiten.

3. Industrieroboter nach Anspruch 2, bei dem der Steuerschrank (10) einen zwischen dem Luftkanal (15) und dem entwärmenden Innenraum (14) angeordneten Wärmetauscher (18) aufweist, wobei insbesondere das Schwungrad (19) eingerichtet ist, den Luftstrom (23) am Wärmetauscher (18) vorbei und/oder über den Wärmetauscher (18) zu leiten.

4. Industrieroboter nach einem der Ansprüche 1 bis 3, bei dem das Schwungrad (19) die Form eines Lüfterrades aufweist.

5. Industrieroboter nach einem der Ansprüche 1 bis 4, bei dem die wenigstens eine elektrische und/oder elektronische Komponente als wenigstens eine der folgenden Komponenten ausgebildet ist: Die Steuervorrichtung (10) oder Leistungselektroniken (13) zum Ansteuern der elektrischen Motoren (9) des Roboterarms (2).

6. Industrieroboter nach einem der Ansprüche 1 bis 5, bei dem die Leistungselektroniken (13) für die Motoren (9) des Roboterarms (2) einen gemeinsamen Gleichrichter (13a) zum Erzeugen einer Gleichspannung aus einer elektrischen Netzwechselspannung oder einer dreiphasigen elektrischen Netzspannung, einen, dem Gleichrichter (13a) nachgeschalteten gemeinsamen Zwischenkreis und dem Zwischenkreis nachgeschaltete, Wechselrichter (13c) umfasst, von denen jeweils einer einen der elektrischen Motoren (9) des Roboterarms (2) mit einer elektrischen Spannung versorgt und insbesondere die Wechselrichter (13c) mittels der Steuervorrichtung (10) ansteuerbar sind.

7. Industrieroboter nach Anspruch 6, bei dem ein Wechselrichter (22) dem elektrischen Motor (21) des Energiespeichers vorgeschaltet ist, der dem gemeinsamen Zwischenkreis der Leistungselektroniken (13) nachgeschaltet ist und der insbesondere mittels der Steuervorrichtung (10) ansteuerbar ist.

8. Industrieroboter nach einem der Ansprüche 1 bis 7, der eingerichtet ist, in einem dritten Betriebsmodus den elektrischen Motor (21) des Energiespeichers im Leerlauf zu betreiben und/oder in einem vierten Betriebsmodus den elektrischen Motor (21) des Energiespeichers mittels elektrischer Energie aus einem elektrischen Versorgungsnetz anzutreiben.

## Claims

1. Industrial robot, comprising
- a robot arm (2) with a plurality of links (3-7) arranged one behind the other and connected by joints and with electric motors (9) for moving the links (3-7) relative to one another,
- a control device (10) for moving the robot arm (2) and
- a control cabinet (10) comprising
- a housing (11),
- at least one electric and/or electronic component (12, 13, 23) arranged inside the housing (11) and
- an electromechanical energy storage device which has an electric motor (21) and a rotatably mounted flywheel (19), which can be set into rotation by means of the electric motor (21) and is configured to generate an air flow (23) for cooling the at least one electric and/or electronic component (12, 13, 23), wherein the industrial robot (1) is configured in a first operating mode to brake at least one of the links (3-7) by means of its motor (9) and to drive the electric motor (21) by means of the thereby produced electrical power so that the latter rotates the flywheel (19) and in a second operating mode to operate the electric motor (21) of the energy storage device in a generator mode, in order to convert energy stored in the rotating flywheel (21) into electrical energy which is provided for driving the electric motors (9) of the robot arm (2).

2. Industrial robot according to claim 1, wherein the control cabinet (10) has a heat sinking inner chamber (15) arranged inside the housing (11), inside which inner chamber the at least one component (12, 13, 23) is arranged, and/or an air channel (15) in which at least the flywheel (19) is arranged for guiding the air flow (23) through the air channel (15).

3. Industrial robot according to claim 2, wherein the control cabinet (10) has a heat exchanger (18) arranged between the air channel (15) and the heat sinking inner chamber (14), wherein in particular the flywheel (19) is configured to guide the air flow (23) past the heat exchanger (18) and/or through the heat exchanger (18).

4. Industrial robot according to any of claims 1 to 3, wherein the flywheel (19) is in the form of a fan propeller.

5. Industrial robot according to any of claims 1 to 4, wherein the at least one electric and/or electronic component is designed as at least one of the following components: the control device (10) or power electronics (13) for controlling the electric motors (9) of the robot arm (2).

6. Industrial robot according to any of claims 1 to 5, wherein the power electronics (13) for the motors (9) of the robot arm (2) comprises a common rectifier (13a) for generating a direct voltage from an electric mains voltage or a three-phase electric mains voltage, a common intermediate circuit downstream of the rectifier (13a) and inverters (13c) arranged downstream of the intermediate circuit, by which respectively one of the electric motors (9) of the robot arm (2) is supplied with electric voltage and in particular the inverters (13c) can be controlled by means of the control device (10).

7. Industrial robot according to claim 6, wherein an inverter (22) is arranged upstream of the electric motor (21) of the energy storage device, which is arranged downstream of the common intermediate circuit of the power electronics (13) and is controlled in particular by means of the control device (10).

8. Industrial robot according to any of claims 1 to 7, which is configured in a third operating mode to operate the electric motor (21) of the energy storage device in idling mode and/or in a fourth operating mode to drive the electric motor (21) of the energy storage device by electric power from an electric mains network.

## Revendications

1. Robot industriel, présentant :
- un bras de robot (2) avec plusieurs membres (3-7) agencés les uns derrière les autres et reliés par l'intermédiaire d'articulations et avec des moteurs électriques (9) pour déplacer les membres (3-7) les uns par rapport aux autres,
- un dispositif de commande (10) pour déplacer le bras de robot (2), et;
- une armoire de commande (10), présentant
- un boîtier (11),
- au moins un composant électrique et/ou électronique (12, 13, 23) agencé à l'intérieur du boîtier (11), et
- un accumulateur d'énergie électromécanique qui présente un moteur électrique (21) et un volant d'inertie (19) monté rotatif qui peut être mis en rotation au moyen du moteur électrique (21) et qui est configuré pour engendrer un flux d'air (23) pour refroidir ledit au moins un composant électrique et/ou électronique (12, 13, 23), le robot industriel (1) étant configuré, dans un premier mode de fonctionnement, pour freiner au moins un des membres (3-7) au moyen de son moteur (9) et pour entraîner le moteur électrique (21) au moyen de l'énergie électrique ainsi engendrée, afin que celui-ci fasse tourner le volant d'inertie (19), et, dans un deuxième mode de fonctionnement, pour faire fonctionner le moteur électrique (21) de l'accumulateur d'énergie dans un fonction de générateur pour transformer l'énergie accumulée dans le volant d'inertie (21) qui tourne en une énergie électrique qui est prévue pour entraîner les moteurs électriques (9) du bras de moteur (2).

2. Robot industriel selon la revendication 1, dans lequel l'armoire de commande (10) présente un espace intérieur (16) dissipant la chaleur, agencé à l'intérieur du boîtier (11), à l'intérieur duquel ledit au moins un composant (12, 13, 23) est agencé, et/ou un canal d'air (15) dans lequel est agencé au moins le volant d'inertie (19) pour diriger le flux d'air (23) à travers le canal d'air (15).

3. Robot industriel selon la revendication 2, dans lequel l'armoire de commande (10) présente un échangeur de chaleur (18) agencé entre le canal d'air (15) et l'espace intérieur (14) dissipant la chaleur, le volant d'inertie (19) étant en particulier configuré pour diriger le flux d'air (23) le long de l'échangeur de chaleur (18) et/ou via l'échangeur de chaleur (18).

4. Robot industriel selon l'une des revendications 1 à 3, dans lequel le volant d'inertie (19) présente la forme d'une roue de ventilateur.

5. Robot industriel selon l'une des revendications 1 à 4, dans lequel ledit au moins composant électrique et/ou électronique est réalisé en tant qu'au moins l'un des composants suivants : le dispositif de commande (10) ou les éléments électroniques de puissance (13) pour piloter les moteurs électriques (9) du bras de robot (2).

6. Robot industriel selon l'une des revendications 1 à 5, dans lequel les éléments électroniques de puissance (13) pour les moteurs (9) du bras de robot (2) comprennent un redresseur (13a) commun pour engendrer une tension continue depuis une tension électrique alternative du réseau ou depuis une tension de réseau électrique triphasée, un circuit intermédiaire commun monté en aval du redresseur (13a) et un onduleur (13c) monté en aval du circuit intermédiaire, dont un respectivement alimente un des moteurs électriques (9) du bras de moteur (2) avec une tension électrique et en particulier les onduleurs (13c) peuvent être pilotés au moyen du dispositif de commande (10).

7. Robot industriel selon la revendication 6, dans lequel un onduleur (22) est monté en amont du moteur électrique (21) de l'accumulateur d'énergie qui est monté en aval du circuit intermédiaire commun des éléments électroniques de puissance (13) et qui peut en particulier être piloté au moyen du dispositif de commande (10).

8. Robot industriel selon l'une des revendications 1 à 7, qui est configuré, dans un troisième mode de fonctionnement, pour faire fonctionner le moteur électrique (21) de l'accumulateur d'énergie en marche à vide et/ou, dans un quatrième mode de fonctionnement, pour entraîner le moteur électrique (21) de l'accumulateur d'énergie au moyen de l'énergie électrique provenant d'un réseau d'alimentation électrique.
